# EUROPEAN PATENT SPECIFICATION

(11) **EP 2 659 753 B1**
(45) Date of publication and mention of the grant of the patent: **14.08.2019**
(21) Application number: 10861303.5
(22) Date of filing: 31.12.2010
(51) Int. Cl.: H05K 7/02, H05K 7/14, H05K 5/00, H05K 5/02, H05K 9/00

(54) **GROUNDING STRUCTURE FOR PRINTED CIRCUIT BOARD**
ERDUNGSSTRUKTUR FÜR LEITERPLATTEN
STRUCTURE DE MISE À LA TERRE POUR CARTE DE CIRCUITS IMPRIMÉS

(43) Date of publication of application: 06.11.2013
(73) Proprietor: InterDigital Madison Patent Holdings, 75017 Paris (FR)
(72) Inventor: KIEW, Kian Choy, Beijing 100192 (CN); LIU, Hongtao, Beijing 100192 (CN); ZHANG, Ke, Beijing 102208 (CN)
(74) Representative: Vidon Brevets & Stratégie
(86) International application number: PCT/CN2010/002233
(87) International publication number: WO 2012/088644

(56) References cited:
- WO-A2-2007/039071
- JP-A- 2009 295 738
- KR-A- 20060 022 976
- KR-A- 20070 013 619
- US-A- 5 398 156
- US-A- 5 537 294
- US-A- 5 647 748
- US-A- 5 863 141
- US-A1- 2003 230 429
- US-A1- 2008 074 334

## Description

### TECHNICAL FIELD

The present invention relates to a grounding structure for printed circuit board (PCB).

### BACKGROUND

The PCB is one of the important components of electronic equipment, which generally is fixed to a containing case of the electronic equipment by fastening screws or bending clips.

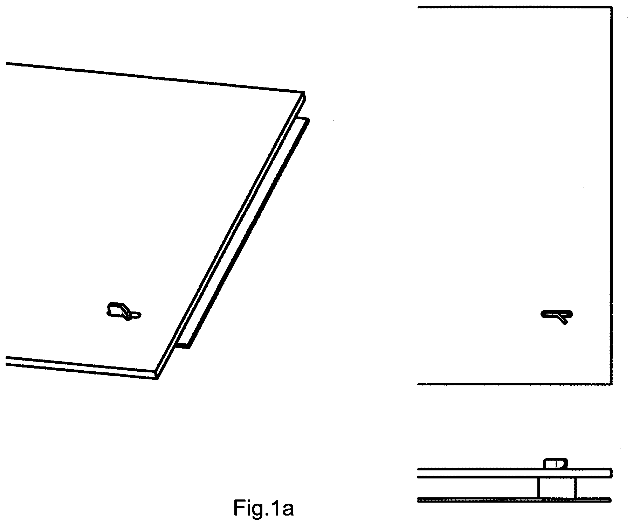

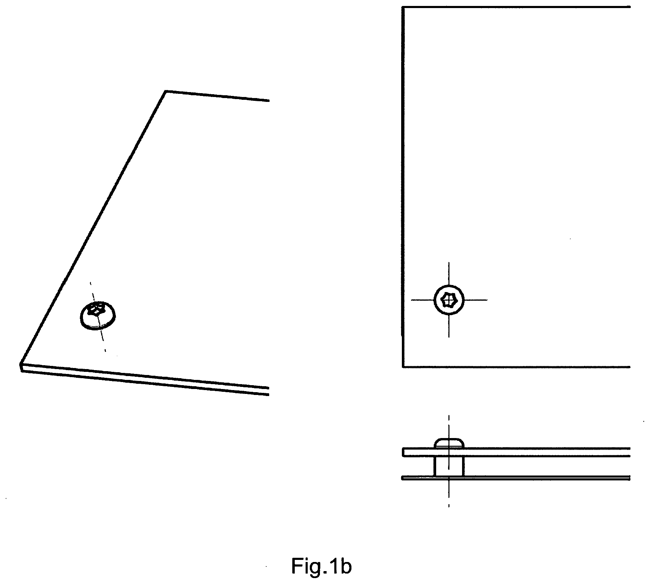

Figure 1a and Figure 1b are exemplary diagrams showing conventional PCB fixing structures. As shown in Figure 1a, the PCB can be locked by a bending clip formed on the containing case. A screw can also be used to firmly fix the PCB onto the containing case, as shown in Figure 1b.

Such solution will cause a number of problems. For instance, a common disadvantage of the prior art structure is that the firmly-fixed PCB is not flexible enough when submitted to shocks, resulting in damage of the circuitry on the PCB. In addition, complicated or inconvenient assembly steps of the screws or clips are required, which will inevitably increase the cost and the possibilities of incorrect manipulation during the manufacture and assembly process. For example, a worker is likely to forget to fasten the screws or the screws may be lost during the assembly procedure.

Patent publication JP 2009/295738 discloses a grounding structure for a printed circuit board which is fixed onto a chassis by a force applied at a first side of the printed circuit board towards the chassis. Although this solution allows a printed circuit board to be fixed on a chassis without using any screw, but rather metal through holes cooperating with corresponding protrusions, it has the drawback that the PCB is altered because of these trough holes. Patent document US 5 398 156 discloses another grounding structure where the metal trough holes and corresponding protrusions are substituted by a system of hook stations and corresponding slots made in the PCB. Once again, this solution allows the PCB to be fixed without any screw but the PCB is also altered because of the slots.

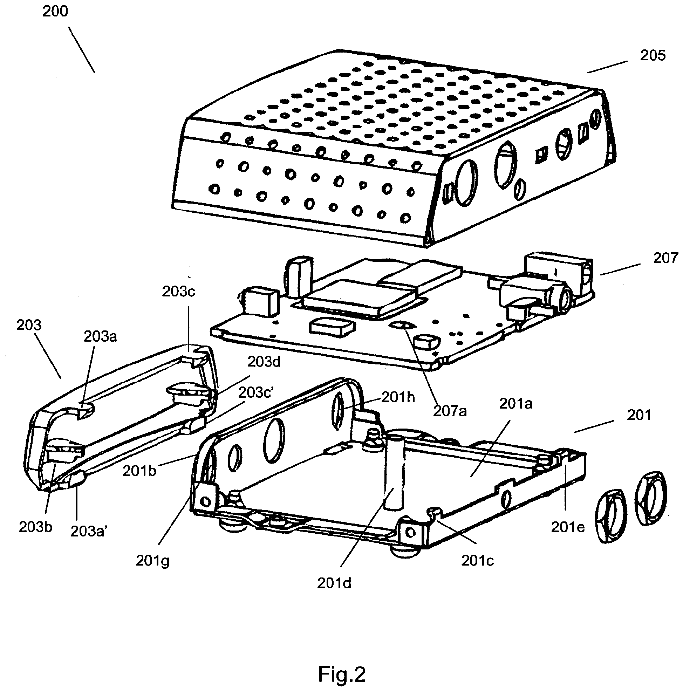

In view of the above-described problems, in European patent application 10165475.4 entitled "apparatus for fixing a printed circuit board", Huang Wenxin et al, filed on June 10, 2009 (hereinafter referred to as prior art 1), an apparatus for fixing a printed circuit board is provided. Figure 2 is a perspective view showing the structure of a containing case, before assembled, for fixing a PCB in accordance with the prior art 1. Referring to Figure 2, the containing case 200 comprises a bottom cover 201, a window member 203 and a top cover 205. A PCB 207 can be fixed and housed in the containing case 200. The bottom cover 201 is used to accommodate the PCB 207. As shown in Figure 2, the bottom cover 201 comprises a bottom board portion 201a and a side wall portion 201b which is disposed upwards in a vertical direction at one edge of the bottom board portion 201a. The bottom board portion 201a can have a shape and size matched with the PCB 207 to receive the PCB 207 thereon. Two clips 201c, 201e are provided at the edge of the board portion 201a opposite to the one where the side wall portion 201b is disposed to lock one side of the PCB 207 after assembly. The bottom board portion 201a is also provided with a pillar 201d which extends upwards in vertical direction. The position of the pillar 201d on the bottom board portion 201a should correspond to that of an opening 207a in the PCB 207 when the PCB 207 is placed on the bottom board portion 201a. During assembly, when the PCB 207 is placed on the bottom board portion 201a in a correction orientation, the pillar 201d will penetrate through the opening 207a in the PCB 207 to hold the PCB 207 in position. It also acts as a guide to ensure correct placing of the PCB on the bottom part 201 of the case.

As shown in Figure 2, the window member 203 has a shape matched with that of the side wall portion 201b of the bottom cover 201. In the prior art 1, the window member 203 is provided with two clips 203a, 203c at its top edge and two clips 203a', 203c' at its bottom edge that all project from the inner side of the front edge of the window member 203 in a direction so as to permit clipping of the window member 203 onto the bottom cover 201. As will be described later, the two clips 203a, 203c, 203a', 203c' can be clipped onto the side wall portion 201b, by which the window member 203 is detachably attached to the bottom cover 201. Two ribs 203b, 203d are integrally formed on the inner side of the window member 203, projecting in the same direction as that of the clips 203a, 203c, 203a', 203c'. The two ribs 203b, 203d protrude orthogonally from the window member 2003, extend downwards and have a predetermined elasticity in that direction. The ribs 203b, 203d can be made of plastic to have the above said required elasticity. The position and extension length of the ribs 203b, 203d are set in such a way that they can respectively penetrate through two openings 201g, 201h in the side wall portion 201b of the bottom cover 201. By pressing with a downward component on the PCB once the window member is clipped into position on the side wall member, the ribs elastically fix the PCB 207 onto the bottom board portion 201a of the bottom cover 201. The top cover 205 can be attached to the bottom cover 201 after the window member 203 is attached to fix the PCB 207 in position, in order to further prevent the PCB 207 from damages caused by dust and other external influences.

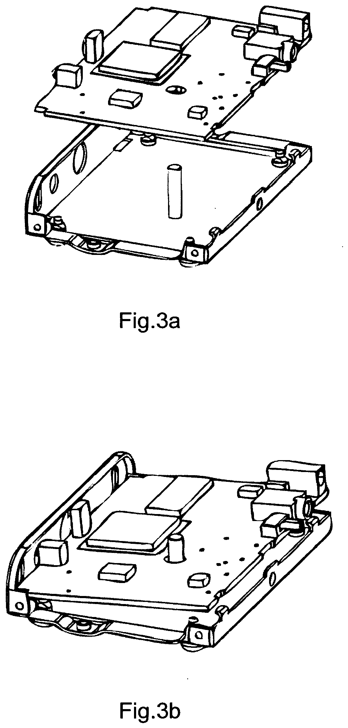

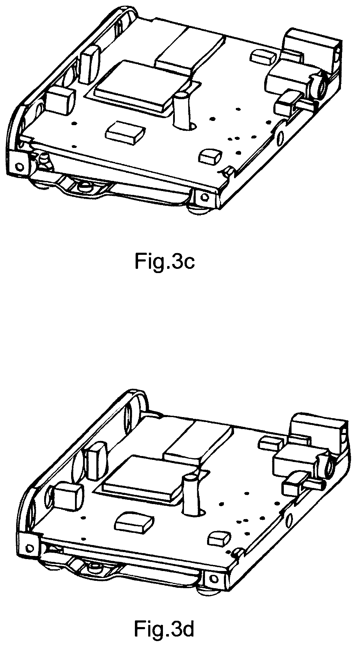

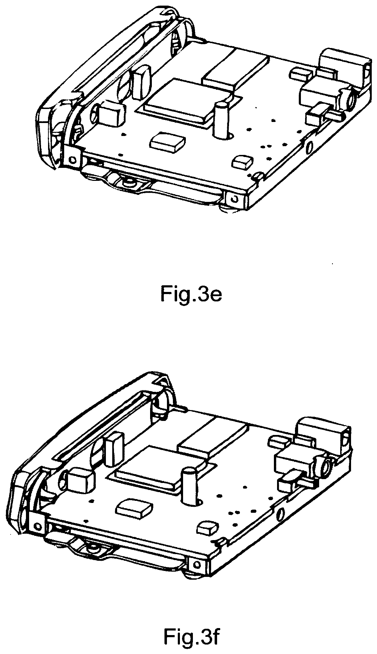

To assemble the PCB 207 into the containing case 200, as shown in Figures 3a and 3b, the PCB 207 is placed onto the bottom board portion 201a of the bottom cover 201 with the pillar 201d penetrating through the opening 207a of the PCB 207 for correctly positioning the PCB 207. Then, in the Figures 3c and 3d a slight push towards the bottom board portion 201a is applied onto the PCB 207 for locking the PCB 207 at one side with the clips 201c, 201e. After the above steps, the PCB 207 is put on the bottom board portion 201a with only one side locked by the clips 201c, 201e. Next, the window member 203 is attached onto the bottom cover 201. As shown in Figure 3e, firstly the ribs 203b, 203d are made to penetrate respectively through corresponding openings 201g, 201h formed on the side wall portion 201b of the bottom cover 201. Then, as illustrated in Figure 3f, a slight force in the assembling direction is applied on the window member 203 to force on the side wall portion 201b, so that the two clips 203a, 203c at the top edge and two clips 203a', 203c' at the bottom edge of the window member 203 are clipped respectively onto the top and bottom edge of the side wall portion 201b of the bottom cover 201 and the two ribs 203b, 203d elastically fix the other side of the PCB 207 onto the bottom cover 201. At this time, the PCB 207 is securely fixed to the containing case 200, with its one side locked by the clips 201c, 201e and the other side elastically fixed by the ribs 203b, 203d.

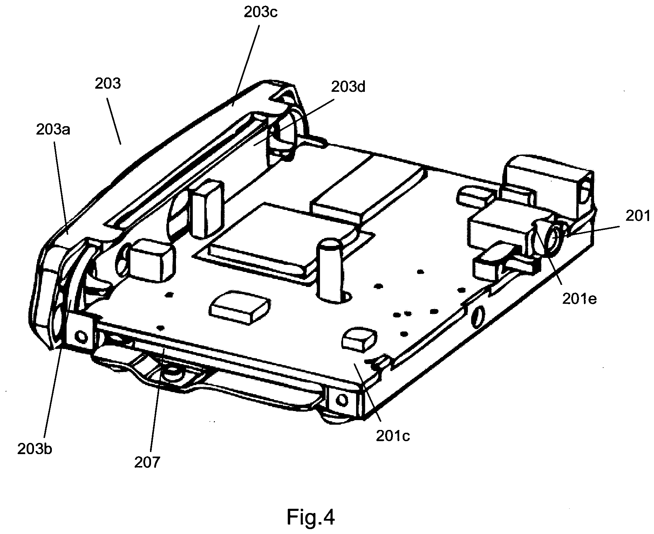

Figure 4 is a perspective view showing the PCB 207 assembled in the containing case 200. As clearly shown in Figure 4, the PCB 207 is locked at one side by the two clips 201c, 201e and elastically fixed at the other side with the two ribs 203b, 203d.

According to the structure proposed by the prior art 1, a PCB can be mounted in a containing case without using separate, mechanically distinct fastening components, such as screws and clips. Therefore, when the window member is assembled in position, the PCB will be automatically fixed by the ribs which are integrally formed on the window member, by which misoperation during the assembly procedure can be avoided. In addition, since the PCB is fixed at one side by the elastic ribs, impact or shock from outer environment can be partly absorbed, which will provide more protections for the electrics devices on the PCB from cracking under impact.

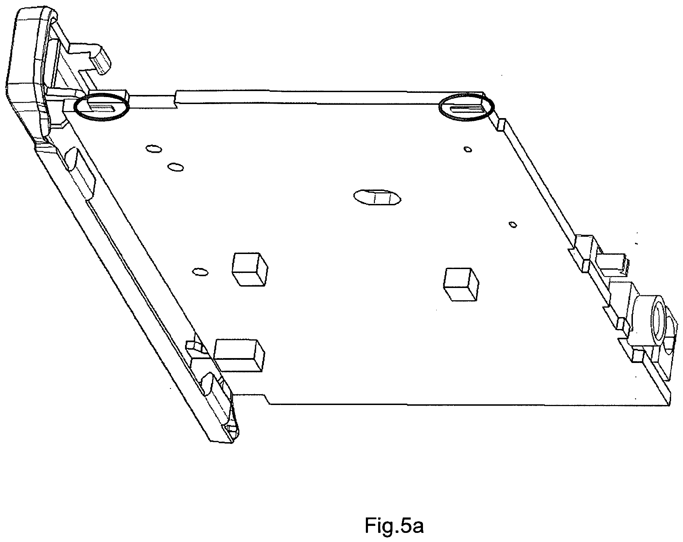

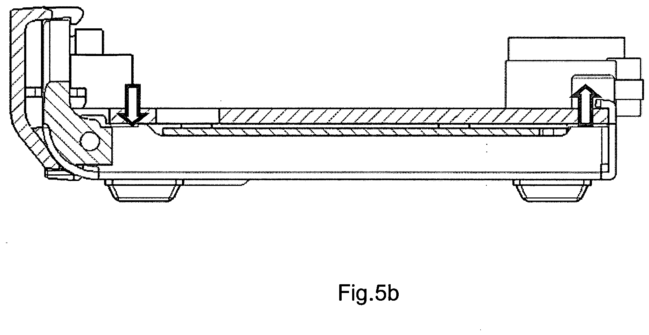

However, when a conventional grounding solution for PCB is used in the above-described PCB fixing structure, a problem may be produced. Figure 5 is an exemplary diagram showing a conventional PCB grounding structure.

Figure 5a is an exemplary diagram showing a perspective view from the bottom side of a PCB with a conventional grounding structure. As shown in Figure 5a, the PCB is provided with two grounding pads indicated by two circles, both at the bottom side, to be in contact respectively with two grounding points (not shown) provided at corresponding positions on chassis (not shown) for accommodating the PCB. It could be appreciated that, for the example in the prior art 1, the chassis refers to the bottom board portion 201a.

Figure 5b is a sectional view showing the PCB with a conventional grounding structure shown in Figure 5a assembled onto a metal frame/chassis by the fixing structure of the prior art 1. As described above, with the fixing structure of the prior art 1, a window member is used to apply a downward force at one side of the PCB, by which the PCB is fixed onto the metal frame/chassis. As shown in Figure 5b, since the PCB is fixed by a downward force at one side, the other side thereof will have a tendency to move upward, which may cause the grounding pad formed on the bottom of the PCB to be out of contact with the chassis. This will lead to a grounding failure, which in turn may influence performance relating to EMC (Electro Magnetic Compatibility)/EMI (Electro Magnetic Interference)/RFI (Radio Frequency Interference).

### SUMMARY

An aspect of the present invention provides a grounding structure for a printed circuit board which is fixed onto a chassis by a force applied at a first side of the printed circuit board towards the chassis. The grounding structure comprises a first grounding pad formed on the bottom surface of the printed circuit board at said first side of the printed circuit board applied with said force; a second grounding pad formed on the top surface of the printed circuit board at a second side opposite to said first side of the printed circuit board; a first grounding point formed on the chassis in a form to be in contact with said first grounding pad from the bottom of the printed circuit board when the printed circuit board is fixed onto the chassis; a second grounding point formed on the chassis in a form to be in contact with said second grounding pad from the top of the printed circuit board when the printed circuit board is fixed onto the chassis; and a supporting point formed on the chassis at a position between the first and the second grounding points for supporting the printed circuit board fixed onto the chassis and for converting said force exerted at said first side of the printed circuit board into another force with opposite direction at said second side of the printed circuit board .

It is to be understood that more aspects and advantages of the invention will be found in the following detailed description of the present invention.

### BRIEF DESCRIPTION OF THE DRAWINGS

The accompanying drawings, which are included to provide a further understanding of the illustrate embodiments of the invention together with the description which serves to explain the principle of the invention. Therefore, the invention is not limited to the embodiments. In the drawings:
Figure 1a and Figure 1b are exemplary diagrams showing conventional PCB fixing structures with fastening screws and bending clips respectively;
Figure 2 is a perspective view showing the structure of a containing case, before assembled, for fixing a PCB;
Figure 3a to Figure 3f are exemplary diagrams showing the procedure of fixing a PCB into the containing case as shown in Figure 2; and
Figure 4 is a perspective view showing the PCB assembled in the containing case as shown in Figure 2;
Figure 5a is an exemplary diagram showing a perspective view from the bottom side of a PCB with a conventional grounding structure;
Figure 5b is a sectional view showing the PCB with a conventional grounding structure shown in Figure 5a assembled onto a metal frame/chassis by the fixing structure of the prior art 1;
Figure 6 is an exemplary diagram showing the PCB grounding structure in accordance with an embodiment of the present invention;
Figure 7a to Figure 7c are exemplary diagrams showing the procedure of assembling a PCB onto a chassis with the grounding structure in accordance with the embodiment of the invention.

### DETAILED DESCRIPTION

An embodiment of the present invention will now be described in detail in conjunction with the drawings. In the following description, some detailed descriptions of known functions and configurations may be omitted for clarity and conciseness.

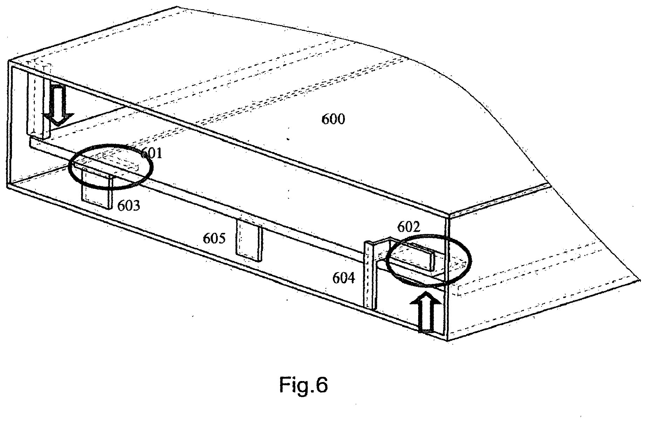

Figure 6 is an exemplary diagram showing the PCB grounding structure in accordance with an embodiment of the present invention. A PCB 600 will be fixed onto a chassis applying the fixing structure described in the prior art 1, that is, applying a pressure at one side of the PCB 600 by the window member to fix the PCB 600 onto a chassis. It can be appreciated that the chassis could be a metal frame in view of the grounding requirement.

As shown in Figure 6, a bottom grounding pad 601 (the part indicated by a circle) is formed on the bottom surface of a PCB 600 at one side of the PCB 600 which will be fixed by the window member described above in the prior art 1, and a top grounding pad 602 (the part indicated by a circle) is formed on the top surface of the PCB at the opposite side of the PCB 600.

Two grounding points 603 and 604 are formed at corresponding positions on the metal frame/chassis to be in contact with the grounding pads 601 and 602 respectively when the PCB 600 is assembled onto the metal frame/chassis. As shown in Figure 6, the grounding point 603 is in a form of a rib which is to be in contact with the bottom grounding pad 601 from the downward direction after the assembly of the PCB 600. While the grounding point 603 is in a form of a bending-up rib which extends above the top surface of the PCB 300 to be in contact with the top grounding pad 602 from the upward direction when the PCB 600 is assembled.

As shown in Figure 6, a rib 605 is formed on the metal frame/chassis at a position between the grounding points 603 and 604, which serves for supporting the PCB 600 when assembled onto the metal frame/chassis.

As described above, a seesaw-like grounding structure for a PCB is provided, which can effectively resolve the grounding failure problem when the PCB is assembled with the fixing structure of the prior art 1. Specifically, when the PCB 600 is fixed onto the metal frame/chassis by the window member in the prior art 1, a downward push force will be applied by the window member onto one side of the PCB 600, which will generate a tight contact between the bottom grounding pad 601 and the grounding point 603. While at the same time, due to the seesaw effect, an upward force will be generated at the other side of the PCB 600 to cause a close-loop contact between the top grounding pad 602 and the grounding point 604. Therefore, a reliable grounding performance is ensured.

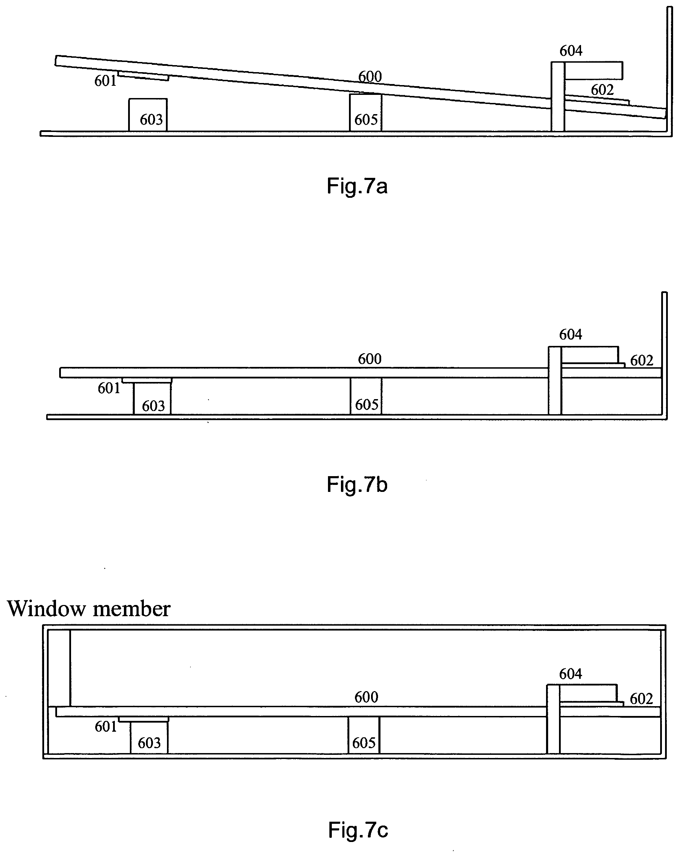

Figure 7a to Figure 7c are exemplary diagrams showing the procedure of assembling a PCB onto a metal frame/chassis of with the grounding structure in accordance with the embodiment of the invention.

As shown in Figure 7a, firstly the PCB 600 will be placed onto the metal frame/chassis, during which course the PCB 600 can be supported by the rib 605 and tilted at a small angle in order that the side of the PCB provided with the top grounding pad 602 is put below the corresponding grounding point 604. It should be careful in this step to avoid the ground pad from being rubbed by the metal frame/chassis.

Next, applying a slight downward force onto the side of the PCB provided with the bottom grounding pad 601 to put the PCB 600 in position where the bottom grounding pad 601 and the top grounding pad 602 are preliminarily contacting with the corresponding grounding points 603 and 604 respectively. This is shown in the Figure 7b.

Finally, as shown in Figure 7c, assembling the PCB 600 onto the metal frame/chassis with the window member described in the prior art 1. In the case, the window member will apply a downward push force on the side of the PCB 600 provided with the bottom grounding pad 601, which will generate a tight contact between the bottom grounding pad 601 and the grounding point 603 provided below the bottom grounding pad 601. At the same time, the above downward push force will be converted, by the supporting rib 605, into an upward force at the other side of the PCB 600 provided with the top grounding pad 602. This upward force will lead to a close-loop contact between the top grounding pad 602 and the grounding point 604 after the PCB 600 is assembled on the metal frame/chassis. Therefore, a reliable grounding performance is achieved at both sides of the PCB 300.

It will be understood that the present invention has been described purely by way of example, and modifications of detail can be made without departing from the scope of the invention. Each feature disclosed in the description and (where appropriate) the claims and drawings may be provided independently or in any appropriate combination.

## Claims

1. A grounding structure for a printed circuit board (600) which is fixed onto a chassis by a force applied at a first side of the printed circuit board (600) towards the chassis by a window member when said window member is assembled to said chassis, the grounding structure comprising:
a first grounding pad (601) formed on the bottom surface of the printed circuit board (600) at said first side of the printed circuit board to which said force is applied;
a second grounding pad (602) formed on the top surface of the printed circuit board (600) at a second side opposite to said first side of the printed circuit board;
a first grounding point (603) formed on the chassis in a form to be in contact with said first grounding pad (601) from the bottom of the printed circuit board (600) when the printed circuit board (600) is fixed onto the chassis;
a second grounding point (604) formed on the chassis in a form to be in contact with said second grounding pad (602) from the top of the printed circuit board (600) when the printed circuit board (600) is fixed onto the chassis; and
a supporting point formed (605) on the chassis at a position between the first (603) and the second (604) grounding points for supporting the printed circuit board (600) fixed onto the chassis and for converting said force exerted by said window member at said first side of the printed circuit board (600) into another force with opposite direction at said second side of the printed circuit board (600).

2. The grounding structure of the claim 1, wherein the first grounding point (603) and the supporting point (605) are in a form of a rib.

3. The grounding structure of the claim 1, wherein the second grounding point (604) is in a form of bending-up rib which extends above the top surface of the printed circuit board (600).

4. The grounding structure of the claim 1, wherein the chassis is a metal frame.

## Patentansprüche

1. Gründungsstruktur für eine Leiterplatte (600), die auf ein Chassis durch eine Kraft befestigt ist, die auf eine erste Seite der Leiterplatte (600) in Richtung auf das Chassis durch ein Fensterelement ausgeübt wird, wenn das Fensterelement an dem Chassis montiert wird, wobei die Gründungsstruktur umfasst:
ein erstes Gründungskissen (601), das auf der Unterseite der Leiterplatte (600) auf der ersten Seite der Leiterplatte, auf die die Kraft ausgeübt wird, gebildet ist;
ein zweites Gründungskissen (602), das auf einer Oberseite der Leiterplatte (600) auf einer zweiten Seite gegenüber der ersten Seite der Leiterplatte gebildet ist;
einen ersten Gründungspunkt (603), der auf dem Chassis in einer Form gebildet ist, um in Kontakt mit dem ersten Gründungskissen (601) von der Unterseite der Leiterplatte (600) zu stehen, wenn die Leiterplatte (600) an dem Chassis befestigt ist;
einen zweiten Gründungspunkt (604), der auf dem Chassis in einer Form gebildet ist, um in Kontakt mit dem zweiten Gründungskissen (602) von der Oberseite der Leiterplatte (600) zu stehen, wenn die Leiterplatte (600) an dem Chassis befestigt ist; und
einen Stützpunkt (605), der auf dem Chassis an einer Position zwischen dem ersten (603) und dem zweiten (604) Gründungspunkt gebildet ist, um die Leiterplatte (600), die an dem Chassis befestigt ist, zu stützen und um die Kraft, die vom Fensterelement auf die erste Seite der Leiterplatte (600) ausgeübt wird, in eine andere Kraft mit entgegengesetzter Richtung auf die zweite Seite der Leiterplatte (600) umzuwandeln.

2. Gründungsstruktur nach Anspruch 1, wobei der erste Gründungspunkt (603) und der Stützpunkt (605) in Form einer Rippe sind.

3. Gründungsstruktur nach Anspruch 1, wobei der zweite Gründungspunkt (604) in Form einer hochgebogenen Rippe ist, die sich über die obere Oberfläche der Leiterplatte (600) erstreckt.

4. Gründungsstruktur nach Anspruch 1, wobei das Chassis ein Metallrahmen ist.

## Revendications

1. Structure de mise à la terre pour une carte de circuits imprimés (600) fixée à un châssis par une force appliquée au niveau d'un premier côté de la carte de circuits imprimés (600) en direction du châssis par un élément de fenêtre lorsque ledit élément de fenêtre est monté sur ledit châssis, la structure de mise à la terre comprenant :
une première borne de mise à la terre (601) formé sur la surface inférieure de la carte de circuits imprimés (600) au niveau dudit premier côté de la carte de circuits imprimés sur lequel ladite force est appliquée ;
une deuxième borne de mise à la terre (602) formé sur la surface supérieure de la carte de circuits imprimés (600) au niveau d'un deuxième côté opposé audit premier côté de la carte de circuits imprimés ;
un premier point de mise à la terre (603) formé sur le châssis sous une forme lui permettant d'être en contact avec ladite première borne de mise à la terre (601) à partir de la partie inférieure de la carte de circuits imprimés (600) lorsque la carte de circuits imprimés (600) est fixée au châssis ;
un deuxième point de mise à la terre (604) formé sur le châssis sous une forme lui permettant d'être en contact avec ladite deuxième borne de mise à la terre (602) à partir de la partie supérieure de la carte de circuits imprimés (600) lorsque la carte de circuits imprimés (600) est fixée au châssis ; et
un point de support formé (605) sur le châssis à une position située entre les premier (603) et deuxième (604) points de mise à la terre pour supporter la carte de circuits imprimés (600) fixée au châssis et pour convertir ladite force exercée par ledit élément de fenêtre au niveau dudit premier côté de la carte de circuits imprimés (600) en une autre force présentant une direction opposée au niveau dudit deuxième côté de la carte de circuits imprimés (600).

2. Structure de mise à la terre selon la revendication 1, dans laquelle le premier point de mise à la terre (603) et le point de support (605) présentent la forme d'un ergot.

3. Structure de mise à la terre selon la revendication 1, dans laquelle le deuxième point de mise à la terre (604) présente la forme d'un ergot plié dans sa partie supérieure qui s'étend au-dessus de la surface supérieure de la carte de circuits imprimés (600).

4. Structure de mise à la terre selon la revendication 1, dans laquelle le châssis est un cadre en métal.
